(19) Europäisches Patentamt
European Patent Office
Office européen des brevets

(11) **EP 2 270 890 B1**

(12) **EUROPÄISCHE PATENTSCHRIFT**

(45) Veröffentlichungstag und Bekanntmachung des Hinweises auf die Patenterteilung:
**31.07.2013 Patentblatt 2013/31**

(51) Int Cl.:
***H01L 35/14*** *(2006.01)*

(21) Anmeldenummer: **10182070.2**

(22) Anmeldetag: **13.11.2000**

(54) **Thermoelektrisch aktive Materialien und diese enthaltende Generatoren**

Thermoelectric active materials and generators containing the same

Matériaux thermoélectriques actifs et générateurs les contenant

(84) Benannte Vertragsstaaten:
**BE DE FR GB NL**

(30) Priorität: **19.11.1999 DE 19955788**

(43) Veröffentlichungstag der Anmeldung:
**05.01.2011 Patentblatt 2011/01**

(62) Dokumentnummer(n) der früheren Anmeldung(en) nach Art. 76 EPÜ:
**00124259.3 / 1 102 334**

(73) Patentinhaber: **BASF SE**
**67056 Ludwigshafen (DE)**

(72) Erfinder: **Sterzel, Hans-Josef**
**67125, Dannstadt-Schauernheim (DE)**

(56) Entgegenhaltungen:
**EP-A- 0 522 182    GB-A- 1 118 184
US-A- 3 407 037**

- **PATENT ABSTRACTS OF JAPAN Bd. 016, Nr. 403 (E-1254), 26. August 1992 (1992-08-26) & JP 04 133481 A (UBE IND LTD;OTHERS: 01), 7. Mai 1992 (1992-05-07)**
- **PATENT ABSTRACTS OF JAPAN Bd. 1999, Nr. 3, 31. März 1999 (1999-03-31) & JP 10 317086 A (HITACHI LTD), 2. Dezember 1998 (1998-12-02)**
- **KAJIKAWA T ET AL: "Thermoelectric properties of magnesium silicide processed by powdered elements plasma activated sintering method" THERMOELECTRICS, 1997. PROCEEDINGS ICT '97. XVI INTERNATIONAL CONFERENCE ON DRESDEN, GERMANY 26-29 AUG. 1997, NEW YORK, NY, USA,IEEE, US, 26. August 1997 (1997-08-26), Seiten 275-278, XP010275113 ISBN: 0-7803-4057-4**

EP 2 270 890 B1

**Beschreibung**

Die Erfindung betrifft thermoelektrisch aktive Materialien und diese enthaltende Generatoren sowie Verfahren zur Herstellung der thermoelektrisch aktiven Materialien.

Thermoelektrische Generatoren als solche sind seit langem bekannt. p- und n- dotierte Halbleiter, die auf einer Seite erhitzt und auf der anderen Seite gekühlt werden, transportieren elektrische Ladungen durch einen äußeren Stromkreis, an einem Verbraucher im Stromkreis wird dabei elektrische Arbeit verrichtet. Der dabei erzielte Wirkungsgrad der Konversion von Wärme in elektrische Energie wird thermodynamisch durch den Carnot - Wirkungsgrad limitiert. Somit wäre bei einer Temperatur von 1000 K auf der heißen und 400 K auf der "kalten" Seite ein Wirkungsgrad von (1000 - 400) : 1000 = 60 % möglich. Leider werden bis heute nur Wirkungsgrade bis 10 % erzielt.

Einen guten Überblick über Effekte und Materialien gibt z. B. Cronin B. Vining, ITS Short Course on Thermoelectricity, Nov. 8, 1993 Yokohama, Japan.

Gegenwärtig werden thermoelektrische Generatoren in Raumsonden zur Erzeugung von Gleichströmen, für den kathodischen Korrosionsschutz von Pipelines, zur Energieversorgung von Leucht- und Funkbojen, zum Betrieb von Radios und Fernsehapparaten eingesetzt. Die Vorteile der thermoelektrischen Generatoren liegen in ihrer äußersten Zuverlässigkeit, sie arbeiten unabhängig von atmosphärischen Bedingungen wie Luftfeuchte, es erfolgt kein störungsanfälliger Stofftransport, sondern nur ein Ladungstransport; der Betriebsstoff wird kontinuierlich - auch katalytisch ohne freie Flamme- verbrannt, wodurch nur geringe Mengen an CO, $NO_x$ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit paßt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Es brauchte keine Änderung am vorhandenen Tankstehennetz vorgenommen zu werden. Für eine derartige Anwendung wären jedoch Wirkungsgrade größer als 30 % notwendig.

Die Aufgabe der Erfindung besteht deshalb darin, neue, thermoelektrisch aktive Materialien zur Verfügung zu stellen, die höhere Wirkungsgrade als bisher ermöglichen. Kennzeichnend für thermoelektrische Materialien ist der sogenannte Z-Faktor (figure of merit)

$$Z = \frac{\alpha^2 * \sigma}{K}$$

mit dem Seebeck - Koeffizienten $\alpha$, der elektrischen Leitfähigkeit $\sigma$ und der Wärmeleitfähigkeit K.

Eine genauere Analyse ergibt, daß der Wirkungsgrad $\eta$ sich ergibt aus

$$\eta = \frac{T_{hoch} - T_{niedrieg}}{T_{hoch}} * \frac{M - 1}{M + \frac{T_{hoch}}{T_{niedrieg}}}$$

mit $M = \left[1 + \frac{Z}{2}(T_{hoch} - T_{niedig})\right]^{\frac{1}{2}}$ (siehe auch Mat. Sci. and Eng. B29 (1995) 228).

Das Ziel ist damit, ein Material mit einem möglichst hohen Wert für Z und hoher realisierbarer Temperaturdifferenz bereitzustellen. Aus der Sicht der Festkörperphysik sind hierbei viele Probleme zu bewältigen:

Ein hohes $\alpha$ bedingt eine hohe Elektronenbeweglichkeit im Material; d.h. Elektronen (oder Löcher bei p-leitenden Materialien) dürfen nicht stark an die Atomrümpfe gebunden sein. Materialien mit hoher elektrischer Leitfähigkeit weisen meist gleichzeitig eine hohe Wärmeleitfähigkeit auf (Wiedemann - Franzsches Gesetz), wodurch Z nicht günstig beeinflußt werden kann. Gegenwärtig eingesetzte Materialien wie $Bi_2Te_3$, PbTe oder SiGe stellen schon Kompromisse dar. So wird die elektrische Leitfähigkeit durch Legieren weniger herabgesetzt als die Wärmeleitfähigkeit. Deshalb setzt man vorzugsweise Legierungen ein wie z. B. $(Bi_2T_3)_{90} (Sb_2T_3)_5 (Sb_2Se_3)_5$ oder $Bi_{12} Sb_{23} Te_{65}$, wie sie in der US 5, 448, 109 beschrieben sind.

EP-A-0 522 182 betrifft ein Verfahren zur Herstellung eines thermoelektrischen Elements. Dabei können Pulverlegierungen eingesetzt werden, entsprechend der Stöchiometrie $Fe_{1-z}M^1_zSi_2$ mit z im Bereich von 0 bis 0,2, wobei

$M^1$ u. a. Mn, Cr, Co sein kann.

JP 04 133 481 betrifft ein thermoelektrisches Element, bei dem das thermoelektrische Material beispielsweise $Fe_{1-x}Cr_xSi_{2.125}$ sein kann, wobei x im Bereich von 0,02 bis 0,3 liegt. In dieser Verbindung liegt der Si-Gehalt oberhalb von 1,99.

GB-A-1,118,184 betrifft die Verbesserung von thermoelektrischen Vorrichtungen. Das eingesetzte thermoelektrische Material leitet sich ausgehend von Eisendisilizid durch Ersatz eines Teils des Eisens durch Chrom oder Mangan, oder auch durch Kobalt oder Nickel ab.

Für thermoelektrische Materialien mit hohem Wirkungsgrad sind vorzugsweise noch weitere Randbedingungen zu erfüllen. Vor allem müssen sie temperaturstabil sein, um bei Arbeitstemperaturen von 1000 bis 1500 K über Jahre ohne wesentlichen Wirkungsgradverlust arbeiten zu können. Dies bedingt sowohl hochtemperaturstabile Phasen an sich, eine stabile Phasenzusammensetzung, wie auch eine zu vernachlässigende Diffusion von Legierungsbestandteilen in die anliegenden Kontaktmaterialien.

Die Aufgabe wird erfindungsgemäß gelöst durch einen thermoelektrischen Generator mit einem p- oder n-dotierten Halbleitermaterial, wobei das Halbleitermaterial ein ternäres Material nach Anspruch 1 ist.

Die folgenden ternären Silizide sind bevorzugt mit x zwischen 0,01 und 0,99:

Ternäre Silizide

$Al_3SiB_{48}$
$Al_4SiC_4$
$Al_4Si_3C_6$
$Ba_x\,Co_{1-x}Si_{1+x}$
$Ba_xCo_{1-x}Si_2$
$Ba_xCr_{1-x}Si_2$
$Ba_xFe_{1-x}Si_{1+x}$
$Ba_xMn_{1-x}Si_{1+x}$
$Ba_xMo_{1-x}Si_2$
$Ba_xW_{1-x}Si_2$
$Co_{1-x}Cr_xSi_{1+x}$
$Co_xFe_{1-x}Si$
$Co_xMn_{1-x}Si$
$Co_{1-x}Mo_xSi_{1+x}$
$Co_{1-x}W_xSi_{1+x}$
$Co_xCr_{1-x}Si_2$
$Co_xFe_{1-x}Si_{1+x}$
$Co_xMn_{1-x}Si_{1+x}$
$Co_xMo_{1-x}Si_2$
$Co_xW_{1-x}Si_2$
$Cr_xFe_{1-x}Si_{1+x}$
$Cr_xMn_{1-x}Si_{1+x}$
$Cr_xMo_{1-x}Si_2$
$Cr_xW_{1-x}Si_2$
$Fe_xMn_{1-x}Si$
$Fe_{1-x}Mo_xSi_{1+x}$
$Fe_{1-x}W_xSi_{1+x}$
$Mn_{1-x}Mo_xSi_{1+x}$
$Mn_{1-x}W_xSi_{1+x}$
$Mo_xW_{1-x}Si_2$
$Fe_xBa_{1-x}Si_2$
$Fe_xCo_{1-x}Si_{1+x}$
$Fe_xCo_{1-x}Si_2$
$Fe_xCr_{1-x}Si_2$
$Fe_xMn_{1-x}Si_{1+x}$
$Fe_xMo_{1-x}Si_2$
$Fe_xW_{1-x}Si_2$
$Fe_xV_{1-x}Si_2$
$VxBa_{1-x}Si_2$
$V_xCo_{1-x}Si_{1+x}$

$V_xCo_{1-x}Si_2$
$V_xCr_{1-x}Si_2$
$V_xFe_{1-x}Si_{1+x}$
$V_xMn_{1-x}Si_{1+x}$
$V_xMo_{1-x}Si_2$
$V_xW_{1-x}Si_2$
$U_{3-3x}Co_x Si_{5-4x}$
$U_{3-3x}Co_xSi_{5-3x}$
$U_{3-3x}Cr_xSi_{5-3x}$
$U_{3-3x}Fe_xSi_{5-4x}$
$U_{3-3x}Fe_x Si_{5-3x}$
$U_{3-3x}Mn_x Si_{5-4x}$
$U_{3-3x}Mo_xSi_{5-3x}$
$U_{3-3x}W_xSi_{5-3x}$
$U_{3-3x}V_xSi_{5-3x}$

Die Silizide im Sinne der Erfindung können zusätzlich noch bis zu 20 Atom -% der Elemente Fe, Co, Ni, Mn, Mo und Al in Kombination mit den bereits aufgeführten jeweils anderen Elementen enthalten.

Die ternären Legierungen können noch mit bis zu 10 Atom % anderer Elemente, nämlich Na, K, Rb, Cs, Zn, Cd, Al, Ga, In, Sn, Zr, Hf, S, Cu, Ag, Au, Ti, V, Nb, Ta, Cr, Mo, W, Mn, Re, Fe, Co oder Ni legiert werden.

Die Erfindung betrifft auch die vorstehend beschriebenen Halbleitermaterialien. Die Erfindung betrifft auch ein Verfahren zur Herstellung dieser Halbleitermaterialien durch Sintern oder Zusammenschmelzen und nachfolgend Sintern von Mischungen der Elementpulver.

Die erfindungsgemäßen Materialien werden somit nach bekannten Verfahren hergestellt, die Elementverbindungen z.B. durch Sintern der Elementpulver bei hohen Temperaturen, jedoch unterhalb des Schmelzpunkts oder durch Lichtbogenschmelzen im Hochvakuum sowie anschließendes Pulverisieren und Sintern. Der Ausdruck "kombination", wie er vorstehend benutzt wurde, bezieht sich gerade auf diese Herstellung, insbesondere das Sintern.

## Patentansprüche

1.  Thermoelektrischer Generator mit einem p- oder n-dotierten Halbleitermaterial, **dadurch gekennzeichnet, daß** das Halbleitermaterial eines der folgenden ternären Materialien ist:

    mit x zwischen 0,01 und 0,99:

    $Al_3SiB_{48}$
    $Al_4SiC_4$
    $Al_4Si_3C_6$
    $Ba_x Co_{1-x}Si_{1+x}$
    $Ba_xCo_{1-x}Si_2$
    $Ba_xCr_{1-x}Si_2$
    $Ba_xFe_{1-x}Si_{1+x}$
    $Ba_xMn_{1-x}Si_{1+x}$
    $Ba_xMo_{1-x}Si_2$
    $Ba_xW_{1-x}Si_2$
    $Co_{1-x}Cr_xSi_{1+x}$
    $Co_xFe_{1-x}Si$
    $Co_xMn_{1-x}Si$
    $Co_{1-x}Mo_xSi_{1+x}$
    $Co_{1-x}W_xSi_{1+x}$
    $Co_xCr_{1-x}Si_2$
    $Co_xFe_{1-x}Si_{1+x}$
    $Co_xMn_{1-x}Si_{1+x}$
    $Co_xMo_{1-x}Si_2$
    $Co_xW_{1-x}Si_2$
    $Cr_xFe_{1-x}Si_{1+x}$
    $Cr_xMn_{1-x}Si_{1+x}$

$Cr_xMo_{1-x}Si_2$
$Cr_xW_{1-x}Si_2$
$Fe_xMn_{1-x}Si$
$Fe_{1-x}MO_xSi_{1+x}$
$Fe_{1-x}W_xSi_{1+x}$
$Mn_{1-x}Mo_xSi_{1+x}$
$Mn_{1-x}W_xSi_{1+x}$
$Mo_xW_{1-x}Si_2$
$Fe_xBa_{1-x}Si_2$
$Fe_xCo_{1-x}Si_{1+x}$
$Fe_xMn_{1-x}Si_{1+x}$
$Fe_xMo_{1-x}Si_2$
$Fe_xW_{1-x}Si_2$
$Fe_xV_{1-x}Si_2$
$VxBa_{1-x}Si_2$
$V_xCo_{1-x}Si_{1+x}$
$V_xCo_{1-x}Si_2$
$V_xCr_{1-x}Si_2$
$V_xFe_{1-x}Si_{1+x}$
$V_xMn_{1-x}Si_{1+x}$
$V_xMo_{1-x}Si_2$
$V_xW_{1-x}Si_2$
$U_{3-3x}Co_x Si_{5-4x}$
$U_{3-3x}Co_x Si_{5-3x}$
$U_{3-3x}Cr_x Si_{5-3x}$
$U_{3-3x}Fe_x Si_{5-4x}$
$U_{3-3x}Fe_x Si_{5-3x}$
$U_{3-3x}Mn_xSi_{5-4x}$
$U_{3-3x}Mo_x Si_{5-3x}$
$U_{3-3x}W_x Si_{5-3x}$
$U_{3-3x}V_x Si_{5-3x}$

2. Halbleitermaterial, wie es in Anspruch 1 definiert ist.

3. Verfahren zur Herstellung von Halbleitermaterialien gemäß Anspruch 2 durch Sintern oder Zusammenschmelzen und nachfolgend Sintern von Mischungen der Elementpulver.

**Claims**

1. A thermoelectric generator comprising a p-doped or n-doped semiconductor material, wherein said semiconductor material is one of the following ternary materials:

   where x is between 0.01 and 0.99:

   $Al_3SiB_{48}$
   $Al_4SiC_4$
   $Al_4Si_3C_6$
   $Ba_xCo_{1-x}Si_{1+x}$
   $Ba_xCo_{1-x}Si_2$
   $Ba_xCr_{1-x}Si_2$
   $Ba_xFe_{1-x}Si_{1+x}$
   $Ba_xMn_{1-x}Si_{1+x}$
   $Ba_xMo_{1-x}Si_2$
   $Ba_xW_{1-x}Si_2$
   $Co_{1-x}Cr_xSi_{1+x}$
   $Co_xFe_{1-x}Si$
   $Co_xMn_{1-x}Si$

$Co_{1-x}Mo_xSi_{1+x}$
$Co_{1-x}W_xSi_{1+x}$
$Co_xCr_{1-x}Si_2$
$Co_xFe_{1-x}Si_{1+x}$
$Co_xMn_{1-x}Si_{1+x}$
$Co_xMo_{1-x}Si_2$
$Co_xW_{1-x}Si_2$
$Co_xW_{1-x}Si_2$
$Cr_xFe_{1-x}Si_{1+x}$
$Cr_xMn_{1-x}Si_{1+x}$
$Cr_xMo_{1-x}Si_2$
$Cr_xW_{1-x}Si_2$
$Fe_xMn_{1-x}Si$
$Fe_{1-x}Mo_xSi_{1+x}$
$Fe_{1-x}W_xSi_{1+x}$
$Mn_{1-x}Mo_xSi_{1+x}$
$Mn_{1-x}W_xSi_{1+x}$
$Mo_xW_{1-x}Si_2$
$Fe_xBa_{1-x}Si_2$
$Fe_xCo_{1-x}Si_{1+x}$
$Fe_xMn_{1-x}Si_{1+x}$
$Fe_xMo_{1-x}Si_2$
$Fe_xW_{1-x}Si_2$
$Fe_xV_{1-x}Si_2$
$Fe_xV_{1-x}Si_2$
$V_xBa_{1-x}Si_2$
$V_xCo_{1-x}Si_{1+x}$
$V_xCo_{1-x}Si_2$
$V_xCr_{1-x}Si_2$
$V_xFe_{1-x}Si_{1+x}$
$V_xMn_{1-x}Si_{1+x}$
$V_xMo_{1-x}Si_2$
$V_xMo_{1-x}Si_2$
$V_xW_{1-x}Si_2$
$U_{3-3x}Co_xSi_{5-4x}$
$U_{3-3x}Co_xSi_{5-3x}$
$U_{3-3x}Cr_xSi_{5-3x}$
$U_{3-3x}Fe_xSi_{5-4x}$
$U_{3-3x}Fe_xSi_{5-3x}$
$U_{3-3x}Mn_xSi_{5-4x}$
$U_{3-3x}Mo_xSi_{5-3x}$
$U_{3-3x}W_xSi_{5-3x}$
$U_{3-3x}V_xSi_{5-3x}$.

2. A semiconductor material as defined in claim 1.

3. A process for the preparation of semiconductor materials according to claim 2 by sintering or melting together and subsequently sintering mixtures of the elemental powders.

**Revendications**

1. Générateur thermoélectrique présentant un matériau semi-conducteur dopé P ou N, **caractérisé en ce que** le matériau semi-conducteur est un des matériaux ternaires suivants :

x étant situé entre 0,01 et 0,99 :

$Al_3SiB_{48}$

$Al_4SiC_4$

$Al_4Si_3C_6$

$Ba_xCo_{1-x}Si_{1+x}$

$Ba_xCo_{1-x}Si_2$

$Ba_xCr_{1-x}Si_2$

$Ba_xFe_{1-x}Si_{1+x}$

$Ba_xMn_{1-x}Si_{1+x}$

$Ba_xMo_{1-x}Si_2$

$Ba_xW_{1-x}Si_2$

$Co_{1-x}Cr_xSi_{1+x}$

$Co_xFe_{1-x}Si$

$Co_xMn_{1-x}Si$

$Co_{1-x}Mo_xSi_{1+x}$

$Co_{1-x}W_xSi_{1+x}$

$Co_xCr_{1-x}Si_2$

$Co_xFe_{1-x}Si_{1+x}$

$Co_xMn_{1-x}Si_{1+x}$

$Co_xMo_{1-x}Si_2$

$Co_xW_{1-x}Si_2$

$Cr_xFe_{1-x}Si_{1+x}$

$Cr_xMn_{1-x}Si_{1+x}$

$Cr_xMo_{1-x}Si_2$

$Cr_xW_{1-x}Si_2$

$Cr_xW_{1-x}Si_2$

$Fe_xMn_{1-x}Si$

$Fe_{1-x}Mo_xSi_{1+x}$

$Fe_{1-x}W_xSi_{1+x}$

$Mn_{1-x}Mo_xSi_{1+x}$

$Mn_{1-x}W_xSi_{1+x}$

$Mo_xW_{1-x}Si_2$

$Fe_xBa_{1-x}Si_2$

$Fe_xCo_{1-x}Si_{1+x}$

$Fe_xMn_{1-x}Si_{1+x}$

$Fe_xMo_{1-x}Si_2$

$Fe_xW_{1-x}Si_2$

$Fe_xV_{1-x}Si_2$

$V_xBa_{1-x}Si_2$

$V_xCo_{1-x}Si_{1+x}$

$V_xCo_{1-x}Si_2$

$V_xCr_{1-x}Si_2$

$V_xFe_{1-x}Si_{1+x}$

$V_xMn_{1-x}Si_{1+x}$

$V_xMo_{1-x}Si_2$

$V_xW_{1-x}Si_2$

$U_{3-3x}Co_xSi_{5-4x}$

$U_{3-3x}Co_xSi_{5-3x}$

$U_{3-3x}Cr_xSi_{5-3x}$

$U_{3-3x}Fe_xSi_{5-4x}$

$U_{3-3x}Fe_xSi_{5-3x}$

$U_{3-3x}Mn_xSi_{5-4x}$

$U_{3-3x}Mo_xSi_{5-3x}$

$U_{3-3x}W_xSi_{5-3x}$

$U_{3-3x}V_xSi_{5-3x}$

2. Matériau semi-conducteur tel qu'il est défini dans la revendication 1.

3. Procédé pour la production de matériaux semiconducteurs selon la revendication 2 par frittage ou fusion et frittage consécutif de mélanges des poudres élémentaires.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5448109 A
- EP 0522182 A
- JP 04133481 B
- GB 1118184 A